# EUROPEAN PATENT APPLICATION

(11) **EP 4 266 292 A1**
(43) Date of publication of application: **25.10.2023**
(21) Application number: 21905645.4
(22) Date of filing: 10.12.2021
(51) Int. Cl.: G09F 9/00

(54) **LAMP PANEL MODULE AND DISPLAY SCREEN HAVING SAME**

(30) Priority: 15.12.2020 CN 202023040116 U; 27.09.2021 CN 202122356192 U; 26.11.2021 CN 202111427925
(71) Applicant: Shenzhen Leyard Opto-Electronic Co., Ltd., Shenzhen, Guangdong 518110 (CN)
(72) Inventor: ZHENG, Jinlong, Shenzhen, Guangdong 518110 (CN); HUANG, Xuexiang, Shenzhen, Guangdong 518110 (CN); HUANG, Jielan, Shenzhen, Guangdong 518110 (CN); LIU, Yabin, Shenzhen, Guangdong 518110 (CN)
(74) Representative: Tansini, Elio Fabrizio
(86) International application number: PCT/CN2021/137230
(87) International publication number: WO 2022/127716

(57) **Abstract**

A lamp panel module and a display screen having the lamp panel module. The lamp panel module comprises: a support (10); a lamp panel (20), provided at a front side of the support (10); a glue layer (30), provided between the lamp panel (20) and the support (10), the lamp panel (20) being adhered to the support (10) by the glue layer (30); and a rear cover (40), located on a rear side of the support (10) and snap-fitted on the support (10) by a snap-fit structure (50). The problems in the related art that threaded connection easily damages the lamp panel (20) and the lamp panel (20) is easy to deform during long-term use are effectively solved.

## Description

### Cross-Reference to Related Application

The present invention claims the priority to Chinese Patent Application No. 202023040116.8, filed on December 15, 2020 and entitled "Lamp Panel Module and Display Screen Having Lamp Panel Module", Chinese Patent Application No. 202122356192.8, filed on September 27, 2021 and entitled "Lamp Panel Module and Display Screen Having Lamp Panel Module", and Chinese Patent Application No. 202111427925.0, filed on November 26, 2021 and entitled "LED Display Module", the original text of which is incorporated herein for reference.

### Technical Field

The present invention relates to the field of LED displays, and in particular, to a lamp panel module and a display screen having the lamp panel module.

### Background

LED display screen technology becomes more and more mature, and LED display screens have become common display tools indoors and outdoors. Furthermore, various large-scale LED display screens have been widely installed in outdoor environments such as high-rise buildings and iron frames for display and advertisement.

In the related art, an LED display screen is composed of several lamp panel modules. Each lamp panel module includes structures such as a lamp panel and a support. The lamp panel is usually connected to the support by a threaded connection manner. The threaded connection manner increases the procedure, and causes a low production efficiency and increased production cost. During machining threaded holes on the lamp panel and assembling the lamp panel, the lamp panel is easily damaged. Moreover, during long-term use, the lamp panel module in a threaded connection manner is easy to bend and deform, and has a short service life.

### Summary

A main object of the present invention is to provide a lamp panel module and a display screen having the lamp panel module, so as to solve the problems in the related art that threaded connection easily damages a lamp panel and the lamp panel is easy to deform during use.

In order to achieve the object, according to one aspect of the present invention, a lamp panel module is provided, including: a support; a lamp panel, provided at a front side of the support; a glue layer, provided between the lamp panel and the support, the lamp panel being adhered to the support by the glue layer; and
a rear cover, located on a rear side of the support and snap-fitted on the support by a snap-fit structure.

Further, the glue layer is a thermally conductive electronic glue.

Further, the snap-fit structure includes a fastener and a first fastening groove fitting the fastener, wherein the fastener is arranged at a side of the rear cover facing the support in a protruding manner, and the first fastening groove is arranged on the support.

Further, the fastener includes an elastic fastening arm and a fastening block provided on the elastic fastening arm.

Further, the snap-fit structure further includes an insertion block and a second fastening groove fitting the insertion block, wherein the insertion block is arranged on the side of the rear cover facing the support in a protruding manner, the second fastening groove is arranged on the support, and the fastener and the insertion block are located on two opposite sides of the rear cover.

Further, the support includes a frame and reinforcing ribs, wherein the reinforcing ribs include a plurality of transverse reinforcing ribs and a plurality of vertical reinforcing ribs, and the plurality of transverse reinforcing ribs and the plurality of vertical reinforcing ribs are arranged in an intersecting manner and are all arranged inside the frame.

Further, the glue layer completely covers a side of the support facing the lamp panel.

Further, the support is made of a metal material.

Further, the rear cover is provided with a through hole; and/or the rear cover is provided with a notch, and the notch and the fastener are located on a same side of the rear cover.

Further, the snap-fit structure includes a fastener provided separately from the rear cover and a first fastening groove provided on the support, wherein the fastener is snap-fitted with the first fastening groove, and the fastener is provided on a front side of the rear cover in a protruding manner.

Further, the rear cover includes a rear cover body and a connecting piece arranged at a first edge of the rear cover body, the fastener include a connecting portion connected with the connecting piece; and the lamp panel module further includes an insertion structure provided between a second edge of the rear cover body and the support, wherein the first edge and the second edge are arranged opposite to each other.

Further, the connecting piece includes a first connecting piece connected with the rear cover body and perpendicular to the rear cover body, the connecting portion includes two clamping hooks arranged opposite to each other, and the first connecting piece is clamped between the two clamping hooks.

Further, the connecting piece further includes a second connecting piece connected with the first connecting piece and perpendicular to the first connecting piece, the connecting portion further includes an insertion groove provided between the two clamping hooks, and a part of the second connecting piece is inserted into the insertion groove.

Further, the second connecting piece includes a first piece body and a second piece body connected to each other, the first piece body is connected with the first connecting piece, a width of the first piece body is greater than a width of the second piece body, and the second piece body is inserted into the insertion groove.

Further, the fastener further includes an elastic fastening arm connected with the connecting portion and a fastening block provided on the elastic fastening arm, and the fastening block is fastened in the first fastening groove.

Further, the fastener further includes an elastic piece provided on the connecting portion, and the elastic piece is in abutting fit with the support.

Further, the rear cover is made of a metal material, and the fastener is made of a plastic material.

Further, a side of the support facing the rear cover is provided with a cushioning member.

Further, the support includes a frame and a plurality of transverse reinforcing ribs and a plurality of vertical reinforcing ribs arranged in the frame; the plurality of transverse reinforcing ribs and the plurality of vertical reinforcing ribs are arranged in an intersecting manner to form a plurality of accommodating spaces; the plurality of accommodating spaces include a first accommodating space located at a middle position of the support, a second accommodating space located at a first side of the first accommodating space in a transverse direction, and a third accommodating space located at a second side of the first accommodating space in the transverse direction; a cross-sectional area of the first accommodating space is smaller than a cross-sectional area of the second accommodating space, and the cross-sectional area of the first accommodating space is smaller than a cross-sectional area of the third accommodating space; and the lamp panel includes a module circuit, the module circuit including a power supply interface, a signal interface, a first row driving circuit, a second row driving circuit and a column driving circuit, wherein the power supply interface and the signal interface are arranged corresponding to the first accommodating space, a main part of the first row driving circuit and a main part of the column driving circuit are arranged corresponding to the second accommodating space, and a main part of the second row driving circuit is arranged corresponding to the third accommodating space.

Further, the column driving circuit is located at a side of the first row driving circuit away from the first accommodating space.

Further, the module circuit further includes a first signal driving circuit and a second signal driving circuit, the first signal driving circuit is arranged corresponding to the second accommodating space, and the second signal driving circuit is arranged corresponding to the third accommodating space.

Further, the plurality of accommodating spaces further include a fourth accommodating space located above the second accommodating space and a fifth accommodating space located below the second accommodating space, and remaining parts of the first row driving circuit are respectively arranged in the fourth accommodating space and the fifth accommodating space; and the plurality of accommodating spaces further include a sixth accommodating space located above the third accommodating space and a seventh accommodating space located below the third accommodating space, and remaining parts of the second row driving circuit are respectively arranged in the sixth accommodating space and the seventh accommodating space.

Further, a side of the rear cover facing the support is provided with reinforcing ribs, the reinforcing ribs include a plurality of transverse reinforcing ribs and a plurality of vertical reinforcing ribs, and the plurality of transverse reinforcing ribs and the plurality of vertical reinforcing ribs are arranged in a staggered manner; and a rear side of the lamp panel is provided with a first component layout region and a second component layout region, a height of a component in the first component layout region is greater than a height of a component in the second component layout region; and the second component layout region is arranged corresponding to positions of the reinforcing ribs on the rear cover, and the first component layout region corresponds to positions other than the reinforcing ribs on the rear cover.

Further, the glue layer of the lamp panel module includes a first glue layer arranged on the frame and a second glue layer arranged on the transverse reinforcing ribs and arranged on the vertical reinforcing ribs; the second glue layer has a plurality of segments arranged at intervals to avoid intersection positions of the transverse reinforcing ribs and the vertical reinforcing ribs.

Further, a number of the transverse reinforcing ribs is two, a distance between the two transverse reinforcing ribs is a first distance A1, a distance between each transverse reinforcing rib and an adjacent frame is a second distance A2, and a ratio A1/A2 between the first distance A1 and the second distance A2 satisfies: 0.5≤A1/A2≤0.8; and/or a number of the vertical reinforcing ribs is two, a distance between the two vertical reinforcing ribs is a third distance B1, a distance between each vertical reinforcing rib and an adjacent frame is a fourth distance B2, and a ratio B1/B2 between the third distance B1 and the fourth distance B2 satisfies: 1.8≤B1/B2≤2.4.

Further, a position of a rear side of the lamp panel corresponding to the support is provided with an insulating coating.

Further, distances between an IC chip in the module circuit, and the frame, the transverse reinforcing ribs and the vertical reinforcing ribs are 2 mm or more.

According to another aspect of the present invention, a display screen is provided, including a plurality of lamp panel modules, wherein each of the lamp panel modules is the lamp panel module as described above.

By applying the technical solutions of the present invention, the lamp panel module includes a lamp panel, a support, a rear cover, a glue layer and a snap-fit structure. The glue layer is arranged between the lamp panel and the support, so that the lamp panel and the support are adhered together; and the snap-fit structure is arranged between the rear cover and the support, so that the rear cover and the support are snap-fitted together. The above-mentioned structure enables the lamp panel module to be assembled without using screws, and thus machining of threaded holes on the lamp panel, the support and the rear cover is avoided, thereby simplifying the process, reducing the production costs, and improving the production efficiency and the production quality. The glue layer and the snap-fit structure are used to achieve thread-free assembly of the lamp panel module, so that the lamp panel module is able to be quickly assembled and maintained; in addition, the problems in the related art that threaded connection easily damages the lamp panel and the lamp panel is easy to deform during long-term use are effectively solved.

### Brief Description of the Drawings

The drawings of the description, constituting a part of the present invention, are used for providing further understanding of the present invention, and the illustrative embodiments of the present invention and illustrations thereof are used to explain the present invention, rather than constitute inappropriate limitation on the present invention. In the drawing:
Fig. 1 shows a schematic diagram of a three-dimensional structure of Embodiment I of a lamp panel module according to the present invention;
Fig. 2 shows a schematic diagram of an exploded structure of the lamp panel module of Fig. 1;
Fig. 3 shows a schematic sectional view of the lamp panel module of Fig. 1;
Fig. 4 is a schematic enlarged view of part A of the lamp panel module of Fig. 3;
Fig. 5 is a schematic enlarged view of part B of the lamp panel module of Fig. 3;
Fig. 6 shows a schematic diagram of a three-dimensional structure of a support, a glue layer and a lamp panel of the lamp panel module of Fig. 1;
Fig. 7 shows a schematic front view of the lamp panel module of Fig. 1;
Fig. 8 shows a schematic diagram of a three-dimensional structure of a rear cover of the lamp panel module of Fig. 1;
Fig. 9 shows a schematic diagram of a three-dimensional structure of the rear cover of Fig. 8 from another angle;
Fig. 10 shows a schematic rear view of the rear cover of Fig. 8;
Fig. 11 shows a schematic enlarged view of part C of the rear cover of Fig. 10;
Fig. 12 shows a schematic sectional view of the rear cover of Fig. 8;
Fig. 13 shows a schematic enlarged view of part D of the rear cover of Fig. 12;
Fig. 14 shows a schematic enlarged view of part E of the rear cover of Fig. 12;
Fig. 15 shows a rear view of a lamp panel of the lamp panel module of Fig. 1;
Fig. 16 shows a division view of component layout regions of the rear part of the LED lamp panel of Fig. 15;
Fig. 17 shows a schematic rear view of a lamp panel and a support of the lamp panel module of Fig. 1;
Fig. 18 shows a front view of the support of Fig. 17 and a distribution view of a glue layer on the front side of the support;
Fig. 19 shows a schematic diagram of a split structure of Embodiment II of a lamp panel module according to the present invention;
Fig. 20 shows an enlarged view of part F of the lamp panel module of Fig. 19;
Fig. 21 shows a schematic rear view of the lamp panel module of Fig. 19;
Fig. 22 shows an enlarged view of part G of the lamp panel module of Fig. 21;
Fig. 23 shows a schematic enlarged view of a partial structure of the lamp panel module of Fig. 19;
Fig. 24 shows a schematic enlarged view of another partial structure of the lamp panel module of Fig. 19;
Fig. 25 shows a schematic diagram of a split structure of a rear cover and a fastener of the lamp panel module of Fig. 19;
Fig. 26 shows an enlarged view of part H of the rear cover and the fastener of Fig. 25;
Fig. 27 shows a schematic diagram of a three-dimensional structure of the rear cover and the fastener of the lamp panel module of Fig. 19 being assembled together;
Fig. 28 shows an enlarged view of part I of the rear cover and the fastener of Fig. 27;
Fig. 29 shows an enlarged view of part J of the rear cover and the fastener of Fig. 27;
Fig. 30 shows a schematic diagram of a three-dimensional structure of a support of the lamp panel module of Fig. 19;
Fig. 31 shows an enlarged view of part K of the support of Fig. 30;
Fig. 32 shows an enlarged view of part L of the support of Fig. 30; and
Fig. 33 shows a schematic diagram of a three-dimensional structure of a fastener of the lamp panel module of Fig. 19;

The accompanying drawings include the following reference signs:
10, support; 11, frame; 12, reinforcing rib; 121, transverse reinforcing rib; 122, vertical reinforcing rib; 20, lamp panel; 21, first component layout region; 22, second component layout region; 23, insulating coating; 30, glue layer; 31, first glue layer; 32, second glue layer; 40, rear cover; 41, through hole; 42, notch; 43, rear cover body; 44, connecting piece; 441, first connecting piece; 442, second connecting piece; 4421, first piece body; 4422, second piece body; 45, reinforcing rib; 451, transverse reinforcing rib; 452, vertical reinforcing rib; 50, snap-fit structure; 51, fastener; 511, elastic fastening arm; 512, fastening block; 52, first fastening groove; 53, insertion block; 54, second fastening groove; 55, fastener; 551, connecting portion; 5511, clamping hook; 5512, insertion groove; 552, elastic fastening arm; 553, fastening block; 554, elastic piece; 60, cushioning member; 70, accommodating space;71, first accommodating space; 72, second accommodating space; 73, third accommodating space; 74, fourth accommodating space;75, fifth accommodating space; 76, sixth accommodating space; 77, seventh accommodating space; 80, module circuit; 81, power supply interface; 82, signal interface; 83, first row driving circuit; 84, second row driving circuit; 85, column driving circuit; 86, first signal driving circuit; 87, second signal driving circuit; 90, IC chip.

### Detailed Description of the Embodiments

Hereinafter, the technical solutions in the present invention will be described clearly and completely with reference to the accompanying drawings of the present invention. Obviously, the embodiments as described are only some of the embodiments of the present invention, and are not all of the embodiments. The following description of at least one exemplary embodiment is merely illustrative in nature and is in no way intended to limit the present invention and any applications or uses thereof. All other embodiments obtained by a person of ordinary skill in the art on the basis of the present invention without involving any inventive effort shall all fall within the scope of protection of the present invention.

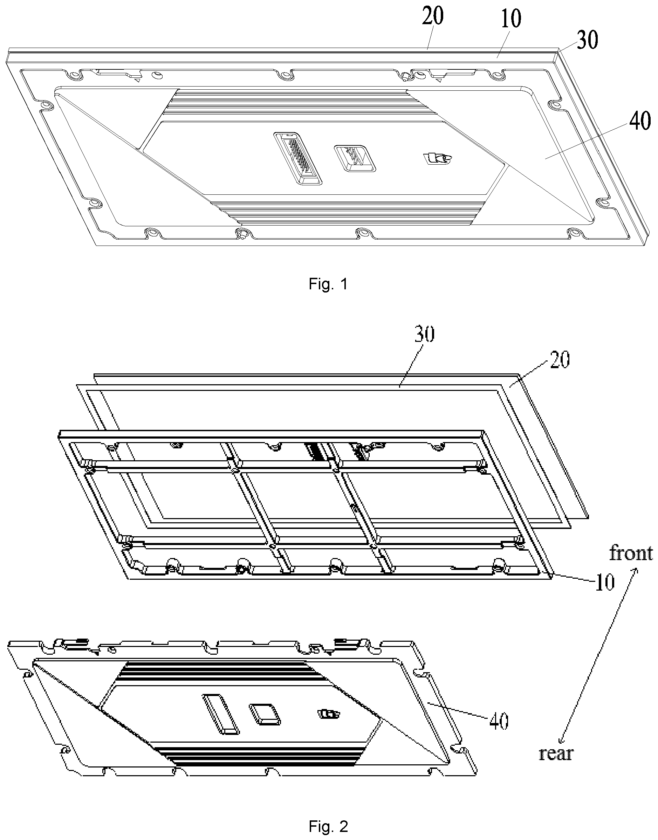

As shown in Figs. 1-3, a lamp panel module of this embodiment includes: a support 10, a lamp panel 20, a glue layer 30 and a rear cover 40. The lamp panel 20 is provided on a front side of the support 10; the glue layer 30 is arranged between the lamp panel 20 and the support 10, and the lamp panel 20 is adhered to the support 10 by the glue layer 30; and the rear cover 40 is located on a rear side of the support 10 and is snap-fitted on the support 10 by a snap-fit structure 50.

By applying the technical solution of this embodiment, the lamp panel module includes a lamp panel 20, a support 10, a rear cover 40, a glue layer 30 and a snap-fit structure 50. The glue layer 30 is arranged between the lamp panel 20 and the support 10, so that the lamp panel 20 and the support 10 are adhered together; and the snap-fit structure 50 is arranged between the rear cover 40 and the support 10, so that the rear cover 40 and the support 10 are snap-fitted together. Machining of threaded holes on the lamp panel 20, the support 10 and the rear cover 40 is avoided, thereby simplifying the process, reducing the production costs, and improving the production efficiency and the production quality. The glue layer 30 and the snap-fit structure 50 are used to achieve thread-free assembly of the lamp panel module, so that the lamp panel module is able to be quickly assembled and maintained; in addition, the problems in the related art that threaded connection easily damages the lamp panel 20 and the lamp panel 20 and the rear cover 40 are easy to deform during long-term use are effectively solved.

In this embodiment, as shown in Fig. 2, the side where the lamp panel 20 is located is the front side, and the side where the rear cover 40 is located is the rear side. In addition, it should be noted that the front side is the side of the lamp panel module facing a user, and is not limited to a front direction in a space. When the lamp panel module is placed in a vertical direction, the lamp panel is located in front of the rear cover; and when the lamp panel module is placed in a horizontal direction, the lamp panel is located above or below the rear cover.

In this embodiment, the glue layer 30 is a thermally conductive electronic glue, specifically a 3M thermally conductive electronic glue. The glue layer uses a thermally conductive electronic glue, and the thermally conductive electronic glue has good thermal conductivity, insulation and adhesion, so that the lamp panel is firmly adhered to the support, and the heat dissipation performance of the lamp panel module is enhanced. Moreover, the 3M thermally conductive electronic glue has good flame retardance, and the flame retardance grade thereof is V-0 grade, thereby improving the safety performance of the lamp panel module during use.

It should be noted that in the present embodiment, in order to take into account both firm adhesion and heat dissipation performance of the lamp panel module, it is preferable to use a 3M electronic glue. Moreover, the use of other models of thermally conductive electronic glues capable of firmly adhering the lamp panel to the support all falls within the scope of protection of the present invention.

The arrangement of the rear cover 40 can prevent lamp panel circuits from being exposed outside, thereby effectively protecting components and prolonging the service life of the product. In this embodiment, considering the issue of reasonable costs, the rear cover is made of a plastic material. In other examples, the rear cover can also be made of metal with good thermal conductivity performance, such as metal aluminum. A rear cover made of aluminum further improves the physical heat dissipation performance of the lamp panel module.

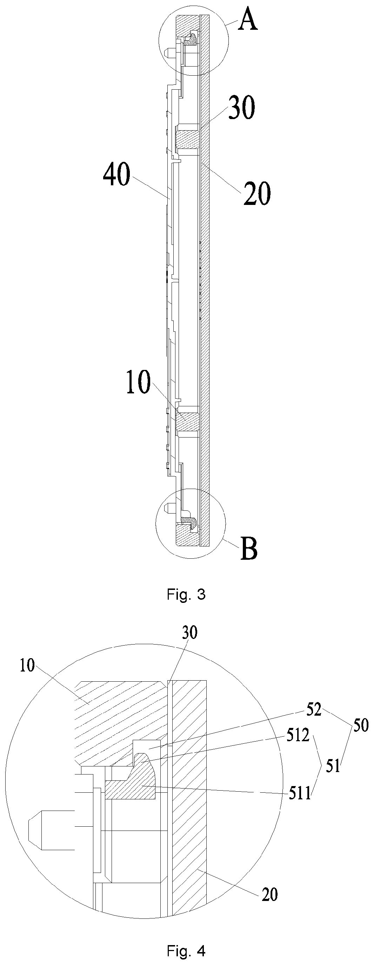

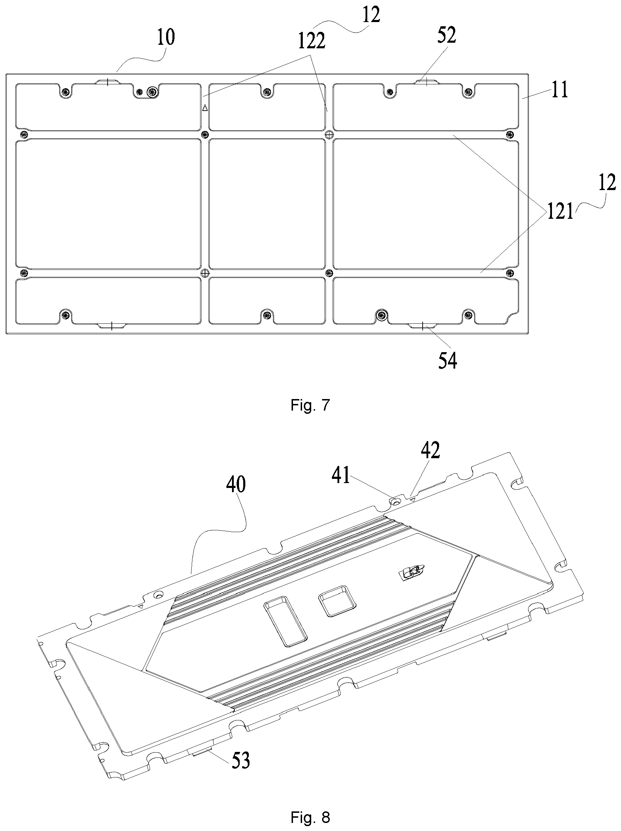

As shown in Figs. 3 and 4, in this embodiment, the snap-fit structure 50 includes a fastener 51 and a first fastening groove 52 fitting the fastener 51. The fastener 51 is arranged on a side of the rear cover 40 facing the support 10 in a protruding manner; and the first fastening groove 52 is arranged on the support 10. The fastener 51 protrudes from a front surface of the rear cover 40, i.e., protrudes from a surface of the side of the rear cover 40 facing the support 10. As shown in Fig. 7, the support 10 includes a frame 11, and the first fastening groove 52 is provided on a lower surface of a top cross beam of the frame 11 and is a recess. During installation, a user extends the fastener 51 below the top cross beam of the frame 11, so that the fastener 51 is snap-fitted in the first fastening groove 52, and thus the rear cover 40 is able to be fixed on the support 10. After installation, the fastener 51 is completely located in a space between the rear cover 40 and the support 10. That is, the fastener 51 is hidden in the space between the rear cover 40 and the support 10. The above-mentioned structure prevents the fastener 51 from being exposed outside, and prolongs the service life of the fastener 51. In addition, during use, the following situation will not occur on the rear cover 40: the rear cover 40 is detached from the support 10 because the user touches the fastener 51 carelessly and the fastener 51 is deformed and disengaged from the first fastening groove 52.

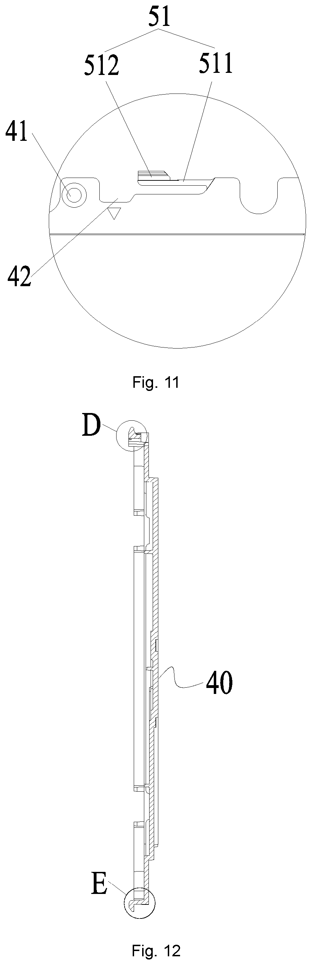

As shown in Figs. 3, 11 and 13, in this embodiment, the fastener 51 includes an elastic fastening arm 511 and a fastening block 512 provided on the elastic fastening arm 511. The front side and the rear side of the fastening block 512 are provided with inclined surfaces. During installation, the user aligns the fastener 51 with the position of the first fastening groove 52, the support 10 is in contact with the inclined surface at the front side of the fastening block 512; under the action of a force applied by the user toward the support 10, the elastic fastening arm 511 is deformed, the fastener 51 is driven by the elastic fastening arm 511 to move downwards, and finally the fastener 51 is snap-fitted in the first fastening groove 52, so that the rear cover 40 is fixed on the support 10.

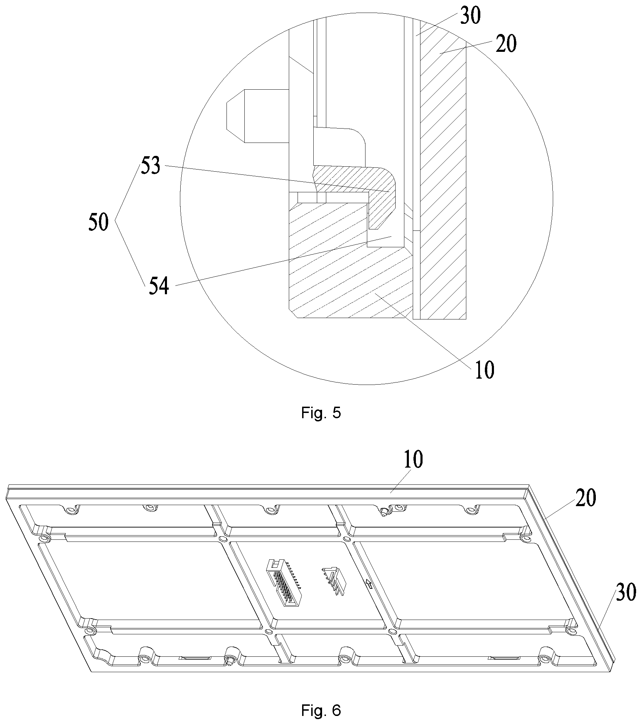

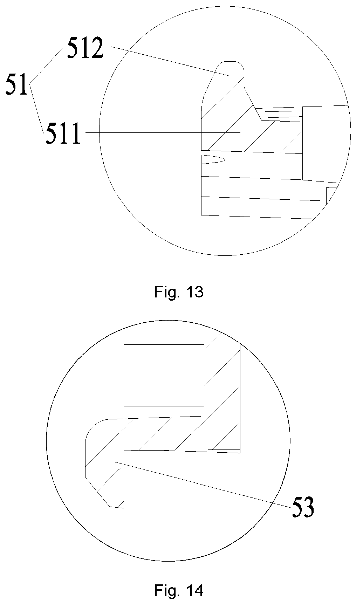

As shown in Figs. 5 and 14, in this embodiment, the snap-fit structure 50 further includes an insertion block 53 and a second fastening groove 54 fitting the insertion block 53; the insertion block 53 is arranged on the side of the rear cover 40 facing the support 10 in a protruding manner, and the second fastening groove 54 is arranged on the support 10, and the fastener 51 and the insertion block 53 are located on two opposite sides of the rear cover 40. The second fastening groove 54 is arranged on an upper surface of a bottom cross beam of the frame 11, and the insertion block 53 extends downwards. As shown in Figs. 3, 7 and 12, in the present embodiment, the fastener 51 is arranged on an upper side wall of the rear cover 40, and the insertion block 53 is arranged on a lower side wall of the rear cover. During installation, the user first inserts the insertion block 53 into the second fastening groove 54, and then enables the fastener 51 to be snap-fitted in the first fastening groove 52, thereby fixing the rear cover 40.

In the present embodiment, the fastener 51 is provided on the upper side wall of the rear cover 40, and the fastening block 512 of the fastener 51 extends upward; and the insertion block 53 is provided on the lower side wall of the rear cover 40 and extends downward. In other feasible examples, the fastener can be arranged on the lower side wall of the rear cover, and correspondingly, the insertion block is arranged on the upper side wall of the rear cover. Moreover, the fastener and the insertion block can also be arranged on left and right side walls of the rear cover, respectively.

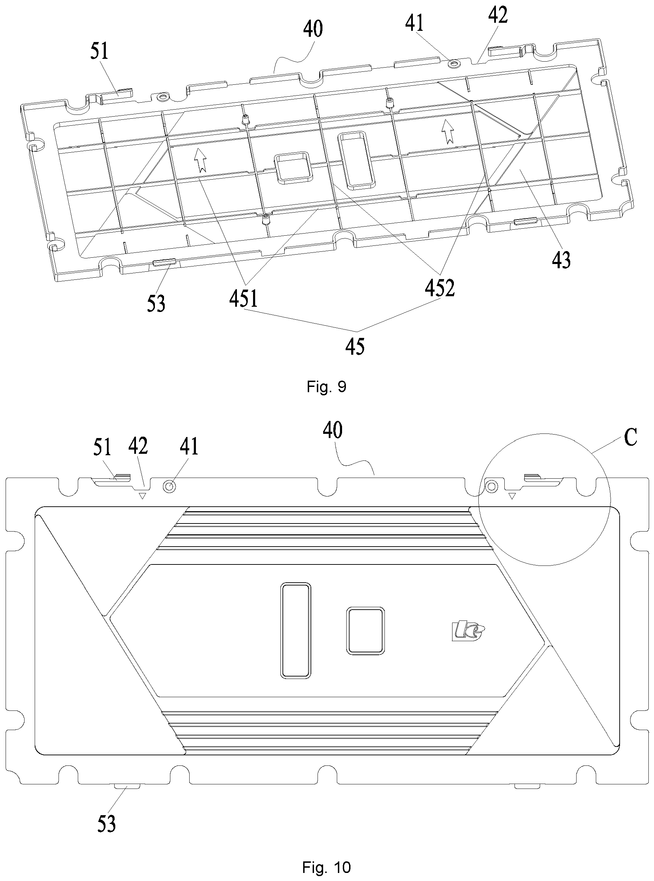

As shown in Fig. 9, in this embodiment, there are two fasteners 51, and there are also two insertion blocks 53 correspondingly.

In other feasible examples, the rear cover can also be fixed on the support by a plurality of fasteners and a plurality of first fastening grooves fitting the plurality of fasteners. The plurality of fasteners are arranged on upper and lower side walls of the rear cover or on left and right side walls of the rear cover, respectively. During installation, the user first snap-fits the fasteners on one side into the first fastening grooves and then snap-fits the fasteners on the other side into the first fastening grooves, thereby fixing the rear cover.

As shown in Fig. 7, the support 10 includes a frame 11 and reinforcing ribs 12; the reinforcing ribs 12 include a plurality of transverse reinforcing rib 121 and a plurality of vertical reinforcing rib 122; and the plurality of transverse reinforcing ribs 121 and the plurality of vertical reinforcing ribs 122 are arranged in an intersecting manner and are all arranged inside the frame 11. As shown in Fig. 7, in this embodiment, the transverse reinforcing ribs 121 and the vertical reinforcing ribs 122 are staggered in traverse and longitudinal directions to form a "#-" shape. A three-dimensional annular space is formed between the plurality of reinforcing ribs 12, which increases the heat dissipation area and enhances the heat dissipation effect of the lamp panel module. The arrangement of the described structure facilitates three-dimensional heat dissipation of the lamp panel module, and improves the service life of the product.

As shown in Fig. 6, in the present embodiment, the glue layer 30 completely covers the side of the support 10 facing the lamp panel 20. The arrangement of the glue layer 30 enables the side surface of the support 10 facing the lamp panel 20 to be all adhered with the glue layer 30, and the lamp panel 20 is firmly adhered to the support 10 via the glue layer 30, so that the lamp panel 20 is not easy to fall off from the support 10.

In this embodiment, the support 10 is made of a metal material, specifically aluminum. Aluminum has advantages of small density, strong corrosion resistance, good thermal conductivity, etc., so that the whole lamp panel module has both light weight and good heat dissipation performance.

In other examples not shown in this embodiment, the support can also be made of other metals having good thermal conductivity.

As shown in Figs. 8-11, in this embodiment, the rear cover 40 is provided with a through hole 41. When the fastener 51 is subject to fatigue damage due to long-term use or is broken accidentally during use and the lamp panel 20 can continue to be used, the user can provide a screw in the through hole 41 to fix the rear cover 40 on the support 10. The arrangement of the through hole 41 takes account of the situation that the fastener 51 may be damaged accidentally during use by the user, thereby avoiding the occurrence of the situations that the whole lamp panel module cannot be used due to the damage of the fastener 51, or the user continues to use the lamp panel module without the protection of the rear cover 40 so that the circuit is directly exposed outside. In addition, the user is provided with more ways of fixing the rear cover 40, which facilitates the use of the user.

Moreover, the rear cover 40 is provided with a notch 42, and the notch 42 and the fastener 51 are located at the same side of the rear cover 40. As shown in Figs. 8-13, in the present embodiment, the notch 42 is located below the elastic fastening arm 511. When it is necessary to detach the rear cover 40, the user can use a tool, such as an object with a certain strength, e.g. a nib, to insert into the position of the notch 42, and to be respectively fastened on a side wall of the notch 42 and a side wall of the support 10, and the user applies a force towards the rear side of the lamp panel module to the rear cover 40, such that the fastener 51 slides out of the first fastening groove 52 along the inclined surface of the rear side of the fastening block 512, so as to realize the detachment of the rear cover 40.

In addition, a triangular identifier is provided at the position of the notch 42, so that the user can quickly find the notch 42 when the user needs to detach the rear cover 40, thereby facilitating the use of the user.

According to another aspect of the present invention, a display screen is provided. Embodiments (not shown in the drawings) of the display screen according to the present invention include a plurality of lamp panel modules, and each lamp panel module is the described lamp panel module. The above-mentioned lamp panel module realizes a thread-free assembly by the arrangements of the glue layer 30 and the snap-fit structure 50, thereby effectively solving the problems in the related art that threaded connection easily damages the lamp panel 20 and the lamp panel 20 and the rear cover 40 are easy to deform during long-term use. Therefore, the display screen having the described lamp panel modules also has the described advantages.

In addition, the arrangement of the glue layer 30 and the snap-fit structure 50 facilitates quick assembly and maintenance of the lamp panel module, thereby improving the production efficiency of components.

As shown in Figs. 1, 2, 15 and 17, the lamp panel module of the present embodiment includes: a support 10, accommodating spaces 70, a lamp panel 20, a module circuit 80 and a rear cover 40. The support 10 includes a frame 11 and a plurality of transverse reinforcing ribs 121 and a plurality of vertical reinforcing ribs 122 arranged in the frame 11, the plurality of transverse reinforcing ribs 121 and the plurality of vertical reinforcing ribs 122 are arranged in an intersecting manner to form a plurality of accommodating spaces 70. The plurality of accommodating spaces 70 include a first accommodating space 71 located at a middle position of the support 10, a second accommodating space 72 located at a first side of the first accommodating space 71 in a transverse direction, and a third accommodating space 73 located at a second side of the first accommodating space 71 in the transverse direction; a cross-sectional area of the first accommodating space 71 is smaller than a cross-sectional area of the second accommodating space 72, and the cross-sectional area of the first accommodating space 71 is smaller than a cross-sectional area of the third accommodating space 73. The lamp panel 20 is provided on the front side of the support 10, the lamp panel 20 includes a module circuit 80, and the module circuit 80 includes a power supply interface 81, a signal interface 82, a first row driving circuit 83, a second row driving circuit 84 and a column driving circuit 85; wherein the power supply interface 81 and the signal interface 82 are arranged corresponding to the first accommodating space 71, a main part of the first row driving circuit 83 and a main part of the column driving circuit 85 are arranged corresponding to the second accommodating space 72, and a main part of the second row driving circuit 84 is arranged corresponding to the third accommodating space 73; and the rear cover 40 is arranged at the rear side of the support 10.

By applying the technical solution of this embodiment, the lamp panel module includes: a support 10, accommodating spaces 70, a lamp panel 20, a module circuit 80 and a rear cover 40. The lamp panel 20 is provided on the front side of the support 10, and the rear cover 40 is provided on the rear side of the support 10. The rear cover 40 can effectively protect components on the rear side of the lamp panel 20, thereby preventing these components from being exposed outside and affecting the service life of the lamp panel module. The support 10 includes a frame 11, and a plurality of transverse reinforcing ribs 121 and a plurality of vertical reinforcing ribs 122 arranged inside the frame 11. The plurality of transverse reinforcing ribs 121 and the plurality of vertical reinforcing ribs 122 are arranged in an intersecting manner to form a plurality of accommodating spaces 70 with different cross-sectional areas. Different parts of the module circuit 80 are respectively arranged corresponding to different accommodating spaces 70, so that the heat dissipation effect of the lamp panel module is better. Specifically, in this embodiment, the main parts of the first row driving circuit 83 and the column driving circuit 85 are arranged in the second accommodating space 72 with a larger cross-sectional area, and the main part of the second row driving circuit 84 is arranged in the third accommodating space 73 with a larger cross-sectional area. These circuits which generate much heat are arranged inside accommodating spaces with larger cross-sectional areas, so that the whole lamp panel module has better heat dissipation performance. Therefore, the technical solution of the present embodiment can effectively solve the problem in the related art that a poor heat dissipation effect of the lamp panel module affects the service life.

In this embodiment, as shown in Figs. 1 and 2, the side where the lamp panel 20 is located is the front side of the support 10, and the side where the rear cover 40 is located is the rear side of the support 10. Two transverse reinforcing ribs 121 and two vertical reinforcing ribs 122 are provided inside the frame 11, the two transverse reinforcing ribs 121 and the two vertical reinforcing ribs 122 form a "#-"-shaped structure, a three-dimensional annular shapes are formed between the transverse reinforcing ribs 121 and the vertical reinforcing ribs 122, and the heat dissipation area is increased.

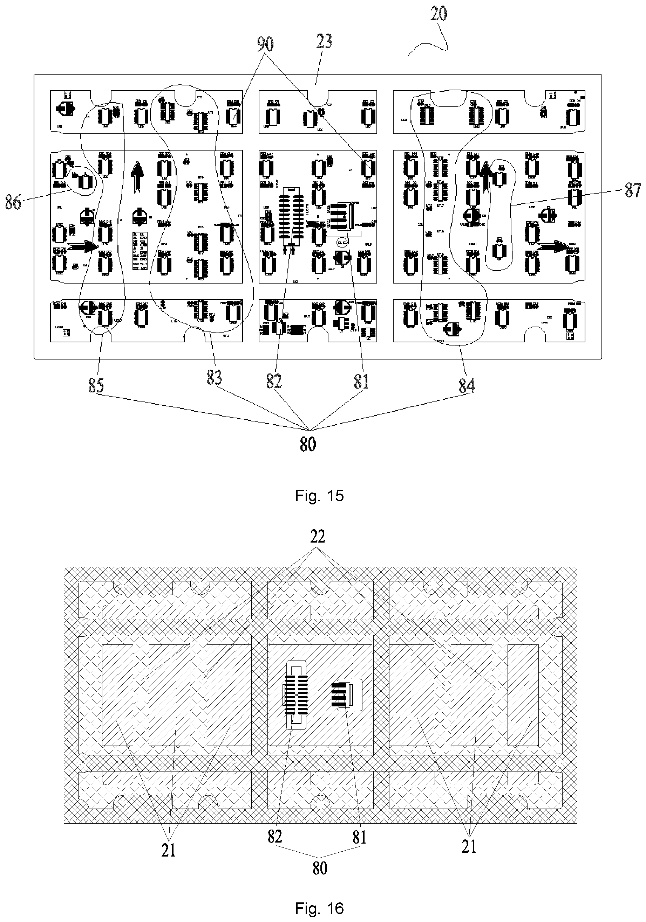

It should be noted that the "cross-sectional area of the first accommodating space 71" refers to a projection area of the first accommodating space 71 on a plane parallel to the front surface of the lamp panel 20. Correspondingly, the cross-sectional areas of the second accommodating space 72 and the third accommodating space 73 are also projection areas on the plane parallel to the front surface of the lamp panel 20. The "main part" of a circuit refers to most IC chips of the circuit, that is, in the present embodiment: most IC chips of the first row driving circuit 83 are arranged corresponding to the second accommodating space 72; most of the column driving circuit 85 is arranged corresponding to the second accommodating space 72; and most of the second row driving circuit 84 is arranged corresponding to the third accommodating space 73. Fig. 15 schematically illustrates the compositions of the first row driving circuit 83, the second row driving circuit 84 and the column driving circuit 85. Of course, an actual circuit composition is not limited to the situation as shown in the figure.

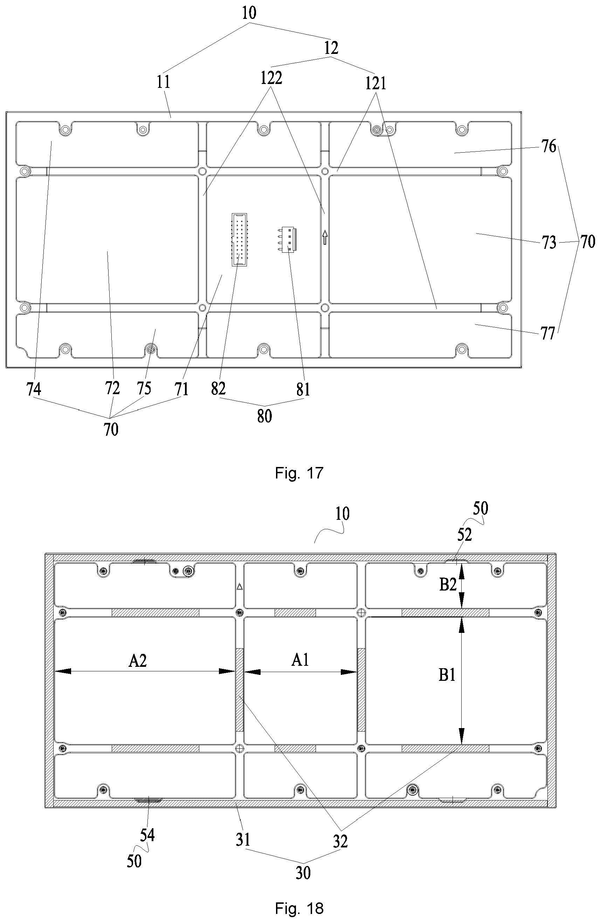

In this embodiment, "a first side of the first accommodating space 71 in a transverse direction" refers to a left side of the first accommodating space 71 in Fig. 17, and "a second side of the first accommodating space 71 in the transverse direction" refers to a right side of the first accommodating space 71 in Fig. 17. Certainly, in other feasible examples, the second accommodating space can also be arranged at the right side of the first accommodating space, and correspondingly, the third accommodating space is arranged at the left side of the first accommodating space, as long as the second accommodating space and the third accommodating space are respectively located at two sides in the transverse direction of the first accommodating space.

As shown in Fig. 15, in the present embodiment, the column driving circuit 85 is located on a side of the first row driving circuit 83 away from the first accommodating space 71. In this way, the circuit layout inside the lamp panel 20 is more reasonable.

As shown in Fig. 15, in this embodiment, the module circuit 80 further includes a first signal driving circuit 86 and a second signal driving circuit 87; the first signal driving circuit 86 is arranged corresponding to the second accommodating space 72, and the second signal driving circuit 87 is arranged corresponding to the third accommodating space 73. In this way, the circuit layout inside the lamp panel 20 is more reasonable.

As shown in Fig. 15, in the present embodiment, the plurality of accommodating spaces 70 further include a fourth accommodating space 74 located above the second accommodating space 72 and a fifth accommodating space 75 located below the second accommodating space 72, and remaining parts of the first row driving circuit 83 are respectively arranged in the fourth accommodating space 74 and the fifth accommodating space 75; the plurality of accommodating spaces 70 further include a sixth accommodating space 76 located above the third accommodating space 73 and a seventh accommodating space 77 located below the third accommodating space 73, and remaining parts of the second row driving circuit 84 are respectively arranged in the sixth accommodating space 76 and the seventh accommodating space 77. The first row driving circuit 83 and the second row driving circuit 84 are respectively arranged in the plurality of accommodating spaces 70, and in this way, IC chips in the circuits are arranged in a dispersed manner, so that heat dissipation is more uniform, and the problem in the related art that a lamp panel module easily generates a high-temperature color band due to uneven heat dissipation is solved.

As shown in Figs. 1, 2, 16 and 9, the side of the rear cover 40 facing the support 10 is provided with reinforcing ribs 45, the reinforcing ribs 45 include a plurality of transverse reinforcing ribs 451 and a plurality of vertical reinforcing ribs 452, and the plurality of transverse reinforcing ribs 451 and the plurality of vertical reinforcing ribs 452 are arranged in a staggered manner; the rear side of the lamp panel 20 is provided with a first component layout region 21 and a second component layout region 22, a height of a component in the first component layout region 21 is greater than a height of a component in the second component layout region 22; the second component layout region 22 is arranged corresponding to the positions of the reinforcing ribs 45 on the rear cover 40, and the first component layout region 21 is arranged corresponding to positions other than the reinforcing ribs 45 on the rear cover 40. The arrangement of the reinforcing ribs 45 enhances the strength of the rear cover 40, thereby improving the overall strength of the lamp panel module. The second component layout region 22 is arranged corresponding to the positions of the reinforcing ribs 45, and components with lower heights are provided in the second component layout region 22, thereby preventing interference between the components and the reinforcing ribs 45.

As shown in Figs. 1, 2 and 18, in the present embodiment, the lamp panel module further includes a glue layer 30 arranged between the lamp panel 20 and the support 10, the lamp panel 20 being adhered to the support 10 by the glue layer 30; the glue layer 30 includes a first glue layer 31 arranged on the frame 11, and a second glue layer 32 arranged on the transverse reinforcing ribs 121 and on the vertical reinforcing ribs 122; the second glue layer 32 has a plurality of segments arranged at intervals to avoid the intersection positions of the transverse reinforcing ribs 121 and the vertical reinforcing ribs 122. The lamp panel 20 and the support 10 are adhered together by the glue layer 30. Specifically, the thermally conductive electronic glue has good thermal conductivity, insulation and adhesion, so that the lamp panel 20 can be firmly adhered to the support 10, thereby achieving a screw-free connection between the support 10 and the lamp panel 20, which can effectively prevent an LED lamp panel from being easily damaged by using screw fixation and connection. The second glue layer 32 includes a plurality of segments of glue layers, and the plurality of segments of glue layers are arranged at intervals, which can reduce the accuracy requirement of glue while ensuring the adhering effect. Specifically, in this embodiment, the interval between the plurality of segments of second glue layers 32 is 40 mm or smaller.

A number of the transverse reinforcing ribs 121 is two, a distance between the two transverse reinforcing ribs 121 is a first distance A1, a distance between each transverse reinforcing rib 121 and an adjacent frame 11 is a second distance A2, and a ratio A1/A2 between the first distance A1 and the second distance A2 satisfies: 0.5≤A1/A2≤0.8; and a number of the vertical reinforcing ribs 122 is two, a distance between the two vertical reinforcing ribs 122 is a third distance B1, a distance between each vertical reinforcing rib 122 and an adjacent frame 11 is a fourth distance B2, and a ratio B1/B2 between the third distance B1 and the fourth distance B2 satisfies: 1.8≤B1/B2≤2.4. While ensuring the strength of the support 10, such an arrangement makes the layout of circuits and electronic components inside the lamp panel module more reasonable. Since the first accommodating space 71 is internally provided with the power supply interface 81 and the signal interface 82 that are plugged with an external power line and a signal line, the structural strength enclosing the first accommodating space 71 needs to be relatively large. When A1/A2<0.5, the distance between the two transverse reinforcing ribs 121 is too small, so that the layout of components such as IC chips in the first accommodating space 71 is too tight, and the heat dissipation effect of the first accommodating space 71 is not good; in addition, the layout of the power supply interface 81 and the signal interface 82 is too compact, not facilitating plugging/unplugging operations of the signal line and the power supply line. When A1/A2>0.8, the structural strength around the first accommodating space 71 is relatively small, and the second accommodating space 72 and the third accommodating space 73 are also relatively small; components such as IC chips in the second accommodating space 72 and the third accommodating space 73 are closely arranged, and the heat dissipation effect is not good. When B1/B2<1.8, the fourth accommodating space 74, the fifth accommodating space 75, the sixth accommodating space 76 and the seventh accommodating space 77 are larger, and correspondingly, more IC chips will be arranged in these accommodating spaces; however, these accommodating spaces are closer to the frame 11, and the frame 11 has a larger width relative to the transverse reinforcing ribs 121 and the vertical reinforcing ribs 122, and the heat dissipation effect is not good. When B1/B2>2.4, the fourth accommodating space 74, the fifth accommodating space 75, the sixth accommodating space 76 and the seventh accommodating space 77 are small, and fewer IC chips can be placed, so that most IC chips are placed in a longitudinal middle position of the lamp panel 20, and such a layout is not reasonable enough.

Specifically, in this embodiment, the ratio A1/A2 between the first distance A1 and the second distance A2 can be 0.5, 0.6, or 0.8; and the ratio B1/B2 between the third distance B1 and the fourth distance B2 is 1.8, 2.1 or 2.4. The value of A1/A2 and the value of B1/B2 are comprehensively set to take into account both ensuring the heat dissipation effect and the structural strength.

As shown in Figs. 1, 2, 15 and 17, in the present embodiment, an insulating coating 23 is provided at a position on the rear side of the lamp panel 20 corresponding to the support 10. The support 10 is a metal support, specifically an aluminum support. The width of the insulating coating 23 is greater than the widths of the transverse reinforcing ribs 121 and the vertical reinforcing ribs 122, thereby preventing the circuits or components on the lamp panel 20 from touching the metal support, thereby affecting the display effect of an LED display module.

In this embodiment, the distances between an IC chip 90 in the module circuit 80 and the frame 11, the transverse reinforcing ribs 121 and the vertical reinforcing ribs 122 are 2 mm or more. Such an arrangement prevents the components from touching the metal support, thereby affecting the display effect of the LED display module.

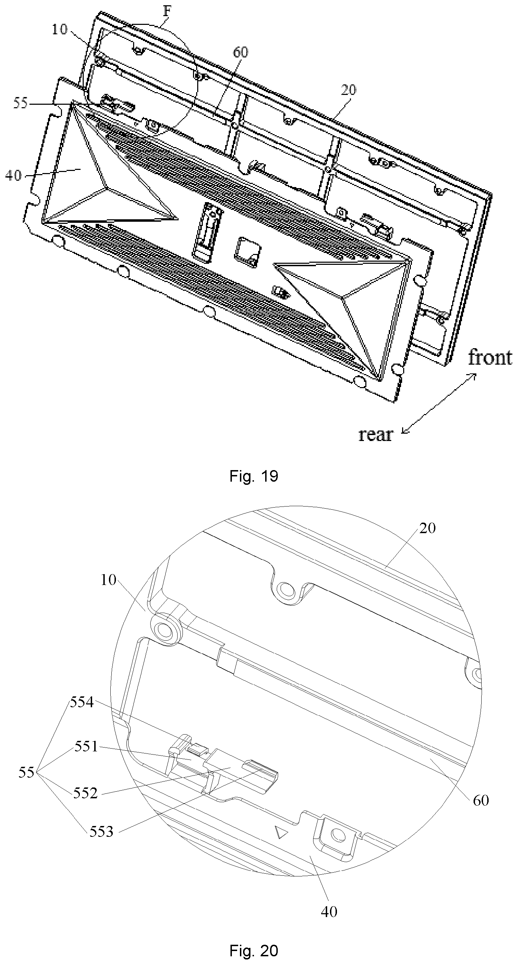

As shown in Figs. 19, 20, 23 and 24, a lamp panel module of the present embodiment includes: a support 10, a lamp panel 20, a rear cover 40 and a snap-fit structure 50. The lamp panel 20 is provided on a front side of the support 10; the rear cover 40 is provided on a rear side of the support 10 and is snap-fitted on the support 10 by the snap-fit structure 50, wherein the snap-fit structure 50 includes a fastener 55 arranged separately from the rear cover 40 and a first fastening groove 52 provided on the support 10, the fastener 55 is in snap-fit with the first fastening groove 52, and the fastener 55 is arranged on a front side of the rear cover 40 in a protruding manner.

By applying the technical solution of this embodiment, the lamp panel module includes a support 10, a lamp panel 20, a rear cover 40 and a snap-fit structure 50. The snap-fit structure 50 is arranged between the support 10 and the rear cover 40, and the installation between the rear cover 40 and the support 10 is achieved by the snap-fit structure 50, so that quick assembly and maintenance between the rear cover 40 and the support 10 is achieved, thereby reducing the production costs and improving the production efficiency. Moreover, the fastener 55 is arranged separately from the rear cover 40 to facilitate machining the fasteners 55 separately, so that the structure of the rear cover 40 is simple and the machining is easier. Therefore, the technical solution of the present embodiment effectively solves the problems in the related art that providing snap-fit structure on a metallic rear cover causes difficult machining of the rear cover and high cost.

The snap-fit structure 50 further includes a first fastening groove 52 provided on the support 10; after the rear cover 40 is installed on the support 10, the fastener 55 is completely located in a space between the rear cover 40 and the support 10, that is, the fastener 55 is hidden in the space between the rear cover 40 and the support 10, thereby preventing the fasteners 55 from being exposed outside, and prolonging the service life of the fastener 55. In addition, during use, the following situation will also be avoided: the rear cover 40 is detached from the support 10 because the user touches the fastener 55 carelessly and the fastener 55 is deformed and disengaged from the first fastening groove 52.

In this embodiment, as shown in Figs. 19, 23 and 24, the side where the lamp panel 20 is located is the front side, and the side where the rear cover 40 is located is the rear side. In addition, it should be noted that the front side is the side of the lamp panel module facing a user, and is not limited to a front direction in a space. When the lamp panel module is placed in a vertical direction, the lamp panel is located in front of the rear cover; and when the lamp panel module is placed in a horizontal direction, the lamp panel is located above or below the rear cover.

In this embodiment, the rear cover 40 is made of a metal material, and the fastener 55 is made of a plastic material. The arrangement of the rear cover 40 prevents lamp panel circuits from being exposed outside, thereby effectively protecting components and prolonging the service life of the product. The rear cover 40 can be made of metal with good thermal conductivity performance, such as metal aluminum. By adopting the rear cover 40 made of aluminum, the lamp panel module has good physical heat dissipation performance. Moreover, the fastener 55 is made of a plastic material, which has good elasticity, low cost, and is easy to produce and manufacture.

In this embodiment, the lamp panel 20 is adhered to the support 10 by using a thermally conductive electronic glue (for example, 3M thermally conductive electronic glue). The thermally conductive electronic glue has good thermal conductivity, insulation, and adhesion, so that the lamp panel can be firmly adhered to the support 10.

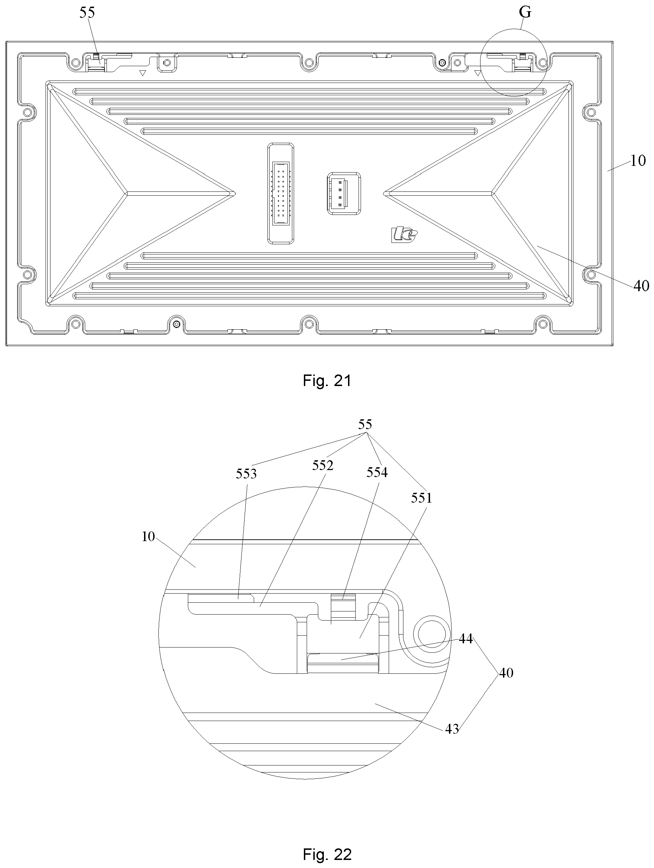

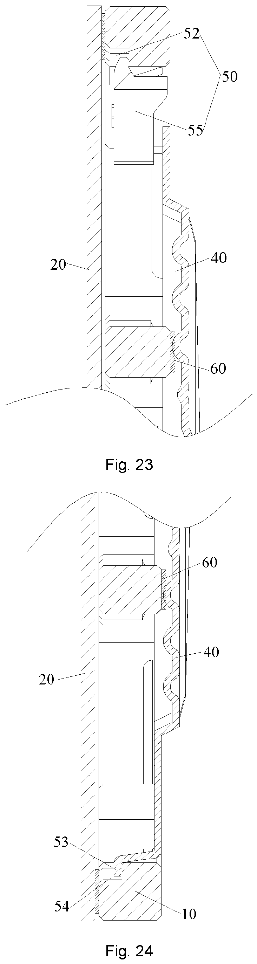

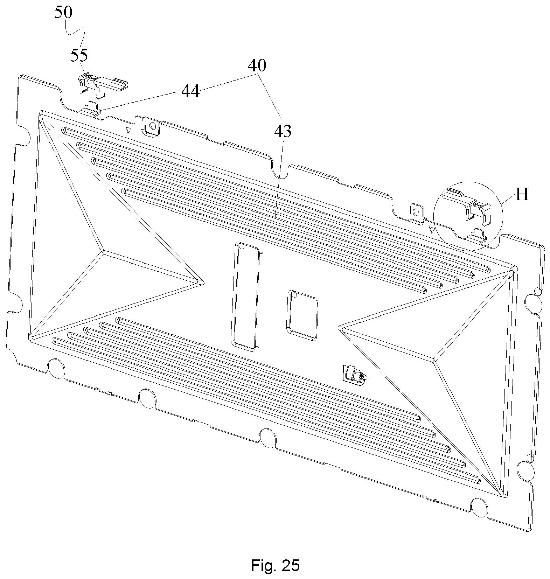

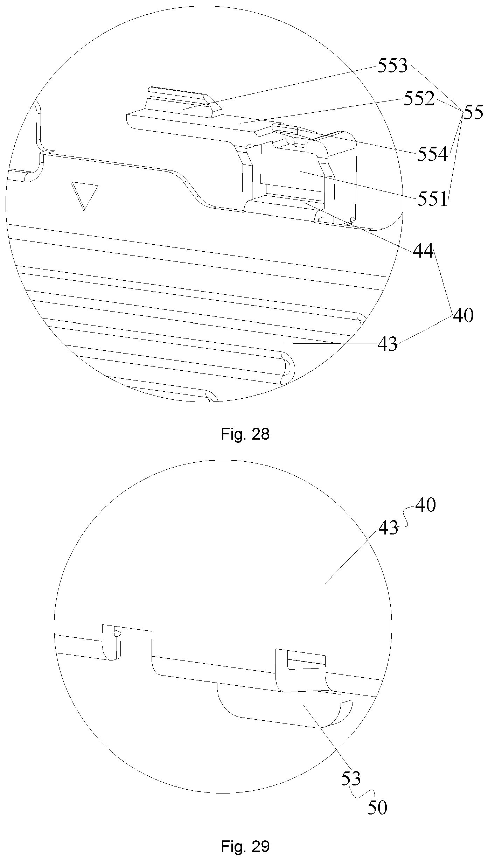

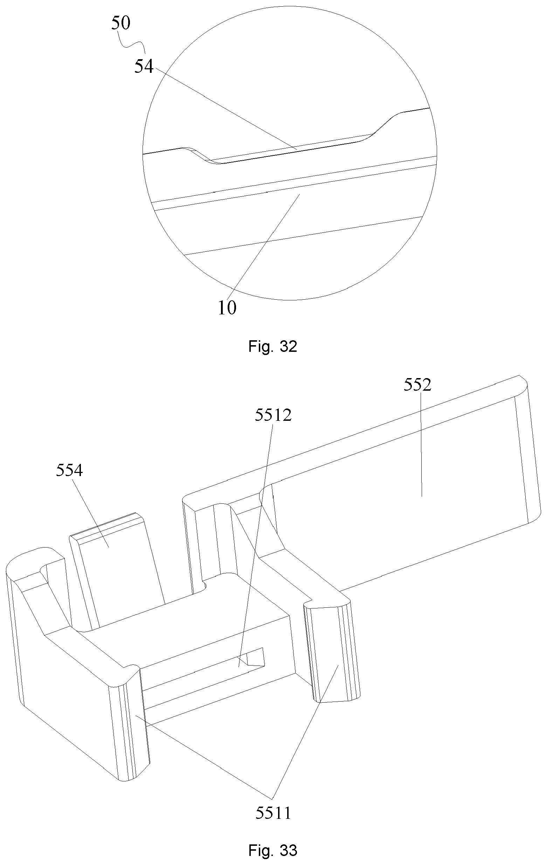

As shown in Figs. 21, 22, 25, 26, 29 and 32, the rear cover 40 includes a rear cover body 43 and a connecting piece 44 arranged at a first edge of the rear cover body 43; the fastener 55 includes a connecting portion 551 connected with the connecting piece 44; and the lamp panel module further includes an insertion structure arranged between a second edge of the rear cover body 43 and the support 10, wherein the first edge and the second edge are arranged opposite to each other. Specifically, the first edge is the upper edge in Fig. 23, and the second edge is the lower edge in Fig. 25. The connecting piece 44 and the rear cover body 43 are of an integrally formed structure, and the connecting piece 44 has the advantage of a simple structure, so that the rear cover 40 can be machined and manufactured more easily. The fastener 55 is connected to the connecting piece 44 by the connecting portion 551, thereby achieving the connection between the fastener 55 and the rear cover 40.

As shown in Figs. 24, 29 and 32, the lamp panel module further includes an insertion structure provided between the second edge of the rear cover body 43 and the support 10. Specifically, the insertion structure includes an insertion block 53 and a second fastening groove 54, wherein the insertion block 53 and the rear cover body 43 are of an integrally formed structure, and the second fastening groove 54 is provided on the support 10. The rear cover 40 is installed on the support 10 by the insertion structure and the snap-fit structure 50, and has the advantage of a simple structure and being easy to install.

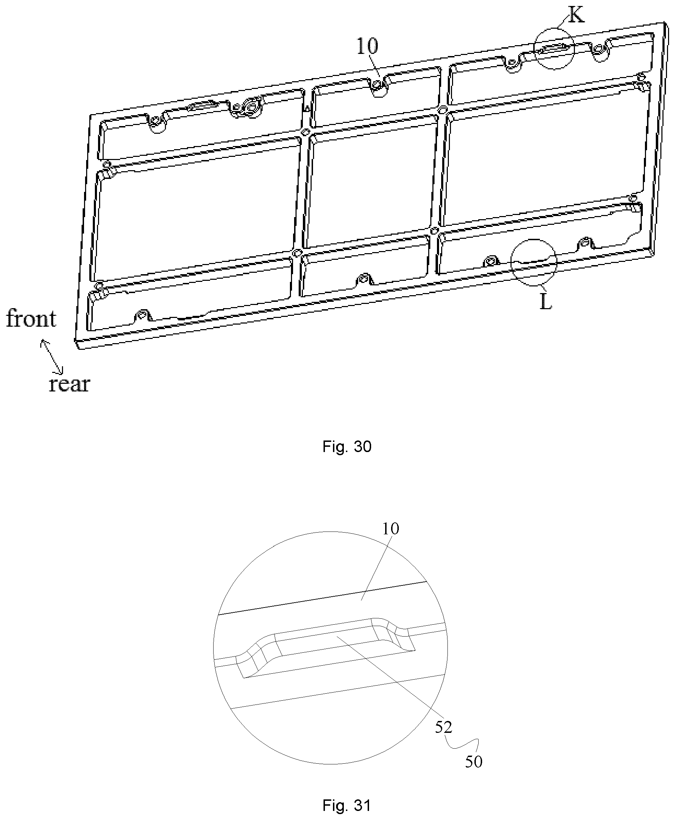

As shown in Fig. 30, in this embodiment, both the second fastening groove 54 and the first fastening groove 52 are arranged on the front side of the support 10 (i.e. the side of the support 10 facing the lamp panel 20), and the fastener 55 and the insertion block 53 are respectively located on two opposite sides of the rear cover 40. The second fastening groove 54 is arranged on the lower surface of a bottom cross beam of the support 10, and the first fastening groove 52 is arranged on the lower surface of an upper cross beam of the support 10. During installation, the user first inserts the insertion block 53 into the second fastening groove 54, and then enables the fastener 55 to be snap-fitted in the first fastening groove 52, thereby installing the rear cover 40.

In the present embodiment, the fastener 55 is provided on the upper side wall of the rear cover 40 and extends upward; and the insertion block 53 is provided on the lower side wall of the rear cover 40 and extends downward. In other feasible examples, the fastener can also be arranged on the lower side wall of the rear cover, and correspondingly, the insertion block is arranged on the upper side wall of the rear cover. Moreover, the fastener and the insertion block can also be arranged on left and right side walls of the rear cover, respectively.

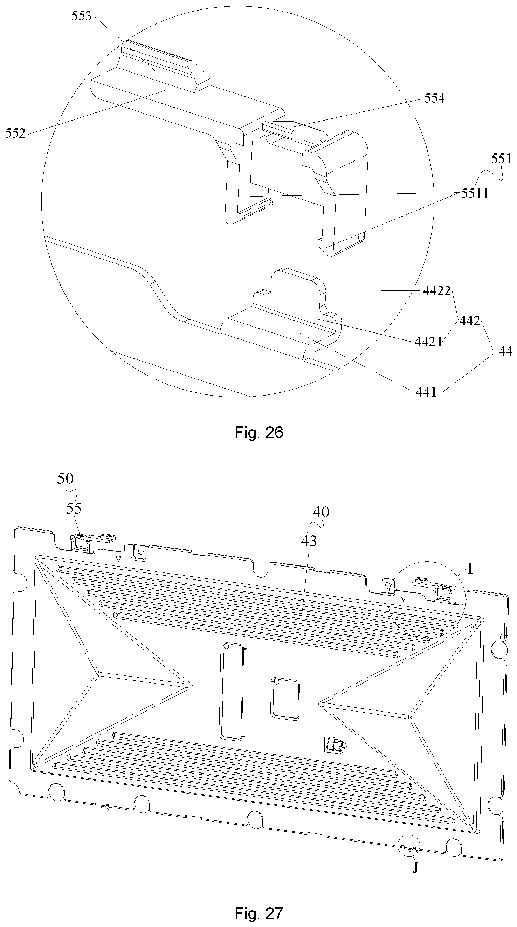

As shown in Figs. 27 to 29, in this embodiment, there are two fasteners 55, there are two insertion blocks 53.

As shown in Figs. 25-28, the connecting piece 44 includes a first connecting piece 441 connected with the rear cover body 43 and perpendicular to the rear cover body 43, the connecting portion 551 includes two clamping hooks 5511 arranged opposite to each other, and the first connecting piece 441 is clamped between the two clamping hooks 5511. The connection between the connecting piece 44 and the fastener 55 is realized by clamping the first connecting piece 441 by the two clamping hooks 5511, and the structure is simple and the operation is easy.

As shown in Figs. 25-28, the connecting piece 44 further includes a second connecting piece 442 connected with the first connecting piece 441 and perpendicular to the first connecting piece 441, the connecting portion 551 further includes an insertion groove 5512 arranged between the two clamping hooks 5511, and a part of the second connecting piece 442 is inserted in the insertion groove 5512. The connecting piece 44 includes the first connecting piece 441 and the second connecting piece 442 connected to each other, and has a simple structure and is easy to produce and manufacture. Moreover, a part of each second connecting piece 442 is inserted in the insertion groove 5512, and tight connection between the fastener 55 and the connecting piece 44 can be achieved by clamping the first connecting piece 441 in cooperation with the two clamping hooks 5511.

It should be noted that "perpendicular to" means that an angle between the first connecting piece 441 and the rear cover body 43 is about 90°. However, the angle between the first connecting piece 441 and the rear cover body 43 can be in the range of 80° to 100° due to manufacturing errors, etc. Likewise, an angle between the first connecting piece 441 and the second connecting piece 442 can also be in the range of 80° to 100°.

As shown in Figs. 25, 26 and 33, in the present embodiment, the second connecting piece 442 includes a first piece body 4421 and a second piece body 4422 connected to each other, the first piece body 4421 is connected with the first connecting piece 441, a width of the first piece body 4421 is larger than a width of the second piece body 4422, and the second piece body 4422 is inserted into the insertion groove 5512. Specifically, the inner sides of the two clamping hooks 5511 are provided with guiding inclined surfaces. During installation, it is only necessary to align the second piece body 4422 with the insertion groove 5512, and the first piece body 4421 pushes the guiding inclined surfaces, so that the two clamping hooks 5511 expand outward and finally clamp two ends of the first connecting piece 441, thereby achieving installation of the fastener 55 and the connecting piece 44. The operation is simple and quick.

As shown in Figs. 27, 28, 30 and 31, the fastener 55 further includes an elastic fastening arm 552 connected with the connecting portion 551 and a fastening block 553 provided on the elastic fastening arm 552, and the fastening block 553 is snap-fitted in the first fastening groove 52. The front side and the rear side of the fastening block 553 are provided with inclined surfaces. During installation, the user aligns the fastener 55 with the position of the first fastening groove 52, the support 10 is in contact with the inclined surface at the front side of the fastening block 553; under the action of a force applied by the user toward the support 10, the elastic fastening arm 552 is deformed, the fastener 55 is driven by the elastic fastening arm 552 to move downwards, and finally the fastener 55 is snap-fitted in the first fastening groove 52, so that the rear cover 40 is fixed on the support 10.

As shown in Figs. 21 and 22, each fastener 55 further includes an elastic piece 554 provided on the connecting portion 551, wherein the elastic piece 554 is in abutting fit with the support 10. After the fastener 55 is installed on the support 10, the elastic piece 554 abuts against the lower side wall of the cross beam on the upper side of the support, which can avoid shaking of the rear cover 40 and ensure stability between the rear cover 40 and the support 10.

As shown in Figs. 19, 20 and 23-24, in the present embodiment, the side of the support 10 facing the rear cover 40 is provided with a cushioning member 60. The cushioning member 60 is provided between the support 10 and the rear cover 40 to avoid collision between the support 10 and the rear cover 40 during installation. Specifically, the cushioning member 60 can be EVA cushioning foam, so that no sound is produced when the rear cover 40 is closed.

Moreover, in this embodiment, the rear cover 40 is provided with protruding ribs, and the arrangement of the protruding ribs increases the heat dissipation area of the rear cover 40 on one hand, and increases the strength of the rear cover 40 on the other hand.

According to another aspect of the present invention, a display screen is provided. Embodiments (not shown in the drawings) of the display screen according to the present invention include a lamp panel module, and the lamp panel module is the described lamp panel module. The lamp panel module includes a support 10, a lamp panel 20, a rear cover 40 and a snap-fit structure 50. The snap-fit structure 50 is arranged between the support 10 and the rear cover 40, and the installation between the rear cover 40 and the support 10 is achieved by the snap-fit structure 50, so that quick assembly between the rear cover 40 and the support 10 is achieved, thereby reducing the production costs and improving the production efficiency. Moreover, the fastener 55 is arranged separately from the rear cover 40 to facilitate machining the fasteners 55 separately, so that the structure of the rear cover 40 is simple and the machining is easier. Therefore, the technical solution of the present embodiment effectively solves the problems in the related art that providing snap-fit structures on a metallic rear cover causes difficult machining of the rear cover and high cost. Therefore, the display screen having the described lamp panel module also has the described advantages.

The content above only relates to preferred embodiments of the present invention and is not intended to limit the present invention. For a person skilled in the art, the present invention may have various modifications and variations. Any modifications, equivalent replacements, improvements, etc. made within the spirit and principle of the present invention shall all fall within the scope of protection of the present invention.

## Claims

1. A lamp panel module, comprising:
a support (10);
a lamp panel (20), provided at a front side of the support (10);
a glue layer (30), provided between the lamp panel (20) and the support (10), the lamp panel (20) being adhered to the support (10) by the glue layer (30); and
a rear cover (40), located on a rear side of the support (10) and snap-fitted on the support (10) by a snap-fit structure (50).

2. The lamp panel module according to claim 1, wherein the glue layer (30) is a thermally conductive electronic glue.

3. The lamp panel module according to claim 1, wherein the snap-fit structure (50) comprises a fastener (51) and a first fastening groove (52) fitting the fastener (51), wherein the fastener (51) is arranged at a side of the rear cover (40) facing the support (10) in a protruding manner, and the first fastening groove (52) is arranged on the support (10).

4. The lamp panel module according to claim 3, wherein the fastener (51) comprises an elastic fastening arm (511) and a fastening block (512) provided on the elastic fastening arm (511).

5. The lamp panel module according to claim 3, wherein the snap-fit structure (50) further comprises an insertion block (53) and a second fastening groove (54) fitting the insertion block (53), wherein the insertion block (53) is arranged on the side of the rear cover (40) facing the support (10) in a protruding manner, the second fastening groove (54) is arranged on the support (10), and the fastener (51) and the insertion block (53) are located on two opposite sides of the rear cover (40).

6. The lamp panel module according to claim 1, wherein the support (10) comprises a frame (11) and reinforcing ribs (12), wherein the reinforcing ribs (12) comprise a plurality of transverse reinforcing ribs (121) and a plurality of vertical reinforcing ribs (122), and the plurality of transverse reinforcing ribs (121) and the plurality of vertical reinforcing ribs (122) are arranged in an intersecting manner and are all arranged inside the frame (11).

7. The lamp panel module according to claim 3, wherein
the rear cover (40) is provided with a through hole (41); and/or,
the rear cover (40) is provided with a notch (42), and the notch (42) and the fastener (51) are located on a same side of the rear cover (40).

8. The lamp panel module according to claim 1, wherein the snap-fit structure (50) comprises a fastener (55) provided separately from the rear cover (40) and a first fastening groove (52) provided on the support (10), wherein the fastener (55) is snap-fitted with the first fastening groove (52), and the fastener (55) is provided on a front side of the rear cover (40) in a protruding manner.

9. The lamp panel module according to claim 8, wherein the rear cover (40) comprises a rear cover body (43) and a connecting piece (44) arranged at a first edge of the rear cover body (43), the fastener (55) comprises a connecting portion (551) connected with the connecting piece (44); and the lamp panel module further comprises an insertion structure provided between a second edge of the rear cover body (43) and the support (10), wherein the first edge and the second edge are arranged opposite to each other.

10. The lamp panel module according to claim 9, wherein the connecting piece (44) comprises a first connecting piece (441) connected with the rear cover body (43) and perpendicular to the rear cover body (43), the connecting portion (551) comprises two clamping hooks (5511) arranged opposite to each other, and the first connecting piece (441) is clamped between the two clamping hooks (5511).

11. The lamp panel module according to claim 10, wherein the connecting piece (44) further comprises a second connecting piece (442) connected with the first connecting piece (441) and perpendicular to the first connecting piece (441), the connecting portion (551) further comprises an insertion groove (5512) provided between the two clamping hooks (5511), and a part of the second connecting piece (442) is inserted into the insertion groove (5512).

12. The lamp panel module according to claim 11, wherein the second connecting piece (442) comprises a first piece body (4421) and a second piece body (4422) connected to each other, the first piece body (4421) is connected with the first connecting piece (4422), a width of the first piece body (4421) is greater than a width of the second piece body (4422), and the second piece body (4422) is inserted into the insertion groove (5512).

13. The lamp panel module according to claim 9, wherein the fastener (55) further comprises an elastic piece (554) provided on the connecting portion (551), and the elastic piece (554) is in abutting fit with the support (10).

14. The lamp panel module according to claim 1, wherein
the support (10) comprises a frame (11) and a plurality of transverse reinforcing ribs (121) and a plurality of vertical reinforcing ribs (122) arranged in the frame (11); the plurality of transverse reinforcing ribs (121) and the plurality of vertical reinforcing ribs (122) are arranged in an intersecting manner to form a plurality of accommodating spaces (70); the plurality of accommodating spaces (70) comprise a first accommodating space (71) located at a middle position of the support (10), a second accommodating space (72) located at a first side of the first accommodating space (71) in a transverse direction, and a third accommodating space (73) located at a second side of the first accommodating space (71) in the transverse direction; a cross-sectional area of the first accommodating space (71) is smaller than a cross-sectional area of the second accommodating space (72), and the cross-sectional area of the first accommodating space (71) is smaller than a cross-sectional area of the third accommodating space (73); and
the lamp panel (20) comprises a module circuit (80), the module circuit (80) comprising a power supply interface (81), a signal interface (82), a first row driving circuit (83), a second row driving circuit (84) and a column driving circuit (85), wherein the power supply interface (81) and the signal interface (82) are arranged corresponding to the first accommodating space (71), a main part of the first row driving circuit (83) and a main part of the column driving circuit (85) are arranged corresponding to the second accommodating space (72), and a main part of the second row driving circuit (84) is arranged corresponding to the third accommodating space (73).

15. The lamp panel module according to claim 14, wherein the column driving circuit (85) is located at a side of the first row driving circuit (83) away from the first accommodating space (71); the module circuit (80) further comprises a first signal driving circuit (86) and a second signal driving circuit (87), the first signal driving circuit (86) is arranged corresponding to the second accommodating space (72), and the second signal driving circuit (87) is arranged corresponding to the third accommodating space (73).

16. The lamp panel module according to claim 15, wherein
the plurality of accommodating spaces (70) further comprise a fourth accommodating space (74) located above the second accommodating space (72) and a fifth accommodating space (75) located below the second accommodating space (72), and remaining parts of the first row driving circuit (83) are respectively arranged in the fourth accommodating space (74) and the fifth accommodating space (75); and
the plurality of accommodating spaces (70) further comprise a sixth accommodating space (76) located above the third accommodating space (73) and a seventh accommodating space (77) located below the third accommodating space (73), and remaining parts of the second row driving circuit (84) are respectively arranged in the sixth accommodating space (76) and the seventh accommodating space (77).

17. The lamp panel module according to claim 14, wherein
a side of the rear cover (40) facing the support (10) is provided with reinforcing ribs (45), the reinforcing ribs (45) comprise a plurality of transverse reinforcing ribs (451) and a plurality of vertical reinforcing ribs (452), and the plurality of transverse reinforcing ribs (451) and the plurality of vertical reinforcing ribs (452) are arranged in a staggered manner; and
a rear side of the lamp panel (20) is provided with a first component layout region (21) and a second component layout region (22), a height of a component in the first component layout region (21) is greater than a height of a component in the second component layout region (22); and the second component layout region (22) is arranged corresponding to positions of the reinforcing ribs (45) on the rear cover (40), and the first component layout region (21) corresponds to positions other than the reinforcing ribs (45) on the rear cover (40).

18. The lamp panel module according to claim 14, wherein the glue layer (30) of the lamp panel module comprises a first glue layer (31) arranged on the frame (11) and a second glue layer (32) arranged on the transverse reinforcing ribs (121) and arranged on the vertical reinforcing ribs (122); the second glue layer (32) has a plurality of segments arranged at intervals to avoid intersection positions of the transverse reinforcing ribs (121) and the vertical reinforcing ribs (122).

19. The lamp panel module according to claim 14, wherein
a number of the transverse reinforcing ribs (121) is two, a distance between the two transverse reinforcing ribs (121) is a first distance A1, a distance between each transverse reinforcing rib (121) and an adjacent frame (11) is a second distance A2, and a ratio A1/A2 between the first distance A1 and the second distance A2 satisfies: 0.5≤A1/A2≤0.8; and/or
a number of the vertical reinforcing ribs (122) is two, a distance between the two vertical reinforcing ribs (122) is a third distance B1, a distance between each vertical reinforcing rib (122) and an adjacent frame (11) is a fourth distance B2, and a ratio B1/B2 between the third distance B1 and the fourth distance B2 satisfies: 1.8≤B1/B2≤2.4.

20. The lamp panel module according to claim 14, wherein a position of a rear side of the lamp panel (20) corresponding to the support (10) is provided with an insulating coating (23).

21. The lamp panel module according to claim 14, wherein distances between an IC chip (90) in the module circuit (80), and the frame (11), the transverse reinforcing ribs (121) and the vertical reinforcing ribs (122) are 2 mm or more.

22. A display screen, comprising a plurality of lamp panel modules, wherein each of the lamp panel modules is the lamp panel module according to any one of claims 1-21.
